# EUROPEAN PATENT APPLICATION

(11) **EP 2 985 793 A1**
(43) Date of publication of application: **17.02.2016**
(21) Application number: 14782926.1
(22) Date of filing: 07.03.2014
(51) Int. Cl.: H01L 33/38, H01L 33/30

(54) **SEMICONDUCTOR LIGHT EMITTING ELEMENT AND METHOD FOR MANUFACTURING SAME**

(30) Priority: 10.04.2013 JP 2013081794
(71) Applicant: Shin-Etsu Handotai Co., Ltd., Tokyo (JP)
(72) Inventor: SAKAI, Kenji, Annaka-shi Gunma 379-0196 (JP); IKEDA, Jun, Annaka-shi Gunma 379-0196 (JP)
(74) Representative: Wibbelmann, Jobst
(86) International application number: PCT/JP2014/001267
(87) International publication number: WO 2014/167773

(57) **Abstract**

The invention is a semiconductor light emitting device successively including a conductive support substrate, a metal layer, and a light emitting part successively including an n-type current spreading layer, an n-type cladding layer, an active layer, a p-type cladding layer, and a p-type current spreading layer, which are made of an AlGaInP-based semiconductor layer. This device also includes a first thin ohmic electrode partially covering the p-type current spreading layer and a second thin ohmic electrode partially provided between the metal and n-type current spreading layers. The first and second thin ohmic electrodes are disposed so as not to overlap when seen from above. The lattice constant of the n-type current spreading layer matches that of the n-type cladding layer. The invention provides a P-side-up metal reflection type of semiconductor light emitting device having high luminance that inhibits increase in thickness of semiconductor layers and keeps current from locally concentrating.

## Description

### BACKGROUND OF THE INVENTION

### 1. Field of the Invention

The present invention relates to a P-side-up light emitting device of metal reflection type and a method of producing this device, and particularly to a light emitting device having high luminous efficiency and a method of producing this device.

### 2. Description of the Related Art

In a conventional AlGaInP-based LED structure, a light emitting part is usually formed on a GaAs substrate. This GaAs substrate absorbs light emitted from the interior of a device, thereby degrading the efficiency of light extraction. To obtain a device having enhanced efficiency of light extraction, the so-called high luminance device, there are accordingly proposed light emitting devices configured to efficiently extract light heading toward the substrate side from the light emitting part.

One way of these is to remove the GaAs substrate and then bond a conductive support substrate to a surface of the light emitting part from which the GaAs substrate has been removed with a metal layer for light reflection interposed therebetween (referred to as a metal reflection type below).

Regarding this metal reflection type of light emitting device, techniques to obtain a light emitting device with high luminance are disclosed.

Patent Document 1 discloses an attempt to optimize arrangement of a P-electrode (an electrode connected to a p-type current spreading layer) and an N-electrode (an electrode connected to a n-type current spreading layer) by disposing the P-electrode and the N-electrode at positions at which these electrodes does not overlap each other, so that light is efficiently extracted to the exterior to enhance the light efficiency.

Patent Document 2 discloses providing a transparent window layer made of a conductive material that has a thickness of 50 µm or more on a layer of a quaternary double hetero (DH) structure, in order to spread current and improve the light extraction efficiency, thereby to enhance its luminous efficiency.

Patent Document 3 discloses a technique to improve the extraction efficiency of emitted light by forming a contact portion (an electrode) on a portion except for just under an electrode on a light extracted side.

To fabricate a high luminance device, it is important not only to enhance the luminous efficiency of a light emitting part but also to achieve efficient light extraction to the exterior by light absorption in the interior of the device or the relationship of a relative position between the light emitting part and an electrode as described above.

For a light emitting device having an n-type surface on which light is extracted (referred to as N-side-up below), on the other hand, the following problem arises: when a voltage applied during operation of the light emitting device, sliver (Ag) is diffused to an active layer constituting a light emitting part from Ag paste used to stick a chip of the light emitting device to a base because of water mixed when the chip of the light emitting device is sealed in a package; the lifetime of the light emitting device thereby becomes easy to degrade, and thus high reliability cannot be achieved.

In other words, use of a light emitting device having a p-type surface on which light is extracted (referred to as P-side-up below) is needed to achieve high reliability.

### CITATION LIST

### PATENT LITERATURE

Patent Document 1:Japanese Unexamined Patent publication (Kokai) No. 2007-258326
Patent Document 2:Japanese Unexamined Patent publication (Kokai) No. 2008-166678
Patent Document 3:Japanese Unexamined Patent publication (Kokai) No. 2011-129724

### SUMMARY OF THE INVENTION

Although the achievement of high reliability needs use of a P-side-up light emitting device as described above, it is more difficult to fabricate a P-side-up light emitting device of metal reflection type with high luminance than the N-side up.

This is because a p-type AlGaInP-based semiconductor layer has a smaller electrical conductivity than does an n-type AlGaInP-based semiconductor layer and is difficult to spread current; light is thereby emitted locally in an active layer just under an electrode on the light extracted side and cannot efficiently be extracted to the exterior.

The arrangement of electrodes is optimized or a thick window layer (or current spreading layer) is used as countermeasures of this problem.

The inventors however found that a problem arises as follows.

Although a light emitting device as disclosed in Patent Document 1 optimizes the arrangement of the P-electrode and the N-electrode so as not to overlap each other, the mismatch rate of their lattice constant is large because a p-type AlGaInP cladding layer, an AlGaInP active layer, and an n-type AlGaInP cladding layer are deposited in this order when a light emitting part is formed by a metalorganic vapor phase epitaxy method (referred to as a MOVPE method below) after a p-type GaP layer (a window layer) is deposited on an n-type GaAs substrate. The luminous efficiency thereby decreases because a high quality crystal cannot be obtained.

The light emitting device disclosed in Patent Document 2 generates warp in its substrate because of a window layer formed with a thickness of 50 µm or more. This warp leads to a decrease in yield of a fabrication process of light emitting device chips. In addition, this semiconductor layer (the window layer) with an increased thickness increases fabrication time and material cost, thereby also increasing production cost.

The light emitting device disclosed in Patent Document 3 is fabricated as the N-side-up. If the polarity (n/p) of conductivity type is reversed in the formation of the light emitting part by the MOVPE method, then a P-side-up light emitting device is obtained. This simple way of reversing the polarity of conductivity type however makes it difficult for current to spread in the p-type semiconductor layer of the light extracted surface as described previously, resulting in a decrease in the luminous efficiency.

The present invention was accomplished in view of the above-described problems. It is an object of the present invention to provide a P-side-up, metal reflection type of semiconductor light emitting device having high luminance that inhibits an increase in thickness of semiconductor layers and keeps current from locally concentrating, and a method of producing this light emitting device.

To achieve this object, the present invention provides a semiconductor light emitting device comprising: a conductive support substrate; a metal layer disposed on the conductive support substrate; a light emitting part disposed above the metal layer, the light emitting part including an n-type current spreading layer, an n-type cladding layer, an active layer emitting light, a p-type cladding layer, and a p-type current spreading layer in this order; a first thin ohmic electrode partially covering the p-type current spreading layer; and a second thin ohmic electrode partially provided between the metal layer and the n-type current spreading layer, wherein each layer of the light emitting part is made of an AlGaInP-based semiconductor layer, the first thin ohmic electrode and the second thin ohmic electrode are disposed so as not to overlap when seen from an upper surface of the semiconductor light emitting device, and the n-type current spreading layer is a semiconductor layer whose lattice constant matches a lattice constant of the n-type cladding layer.

Because each layer of the light emitting part is made of an AlGaInP-based semiconductor layer, and the lattice constant of the n-type current spreading layer matches the lattice constant of the n-type cladding layer, no large band offset due to a hetero interface occurs in the boundary between the n-type current spreading layer and the n-type cladding layer. In addition, because a band offset due to a mixing ratio of Al, Ga, and In can be reduced, spread of current is inhibited in the n-type current spreading layer (the opposite side of the light extracted surface) and current on the side of the p-type current spreading layer (the side of the light extracted surface) is drawn near the second thin ohmic electrode (the electrode opposite to the light extracted surface). Light can thereby be emitted at a position far away from the first thin ohmic electrode (the electrode on the light extracted surface). Thus, a P-side-up, metal reflection type of semiconductor light emitting device having high luminance can be obtained.

The lattice constant of the n-type current spreading layer preferably matches the lattice constant of the n-type cladding layer at a lattice constant mismatching rate of 0.5% or less.

When the lattice constant mismatching rate between the n-type current spreading layer and the n-type cladding layer is 0.5% or less, the spread of current is more effectively inhibited in the n-type current spreading layer (the opposite side of the light extracted surface), and the light emitting device can achieve higher luminance.

Moreover, the light emitting part preferably has a total thickness of 10 µm or less.

The light emitting part having a total thickness of 10 µm or less can effectively inhibit warp of a wafer, thereby preventing a decrease in yield of a fabrication process of light emitting device chips.

To achieve the above object, the present invention also provides a method of producing the above semiconductor light emitting device, comprising: forming the light emitting part on a GaAs substrate; forming the second thin ohmic electrode on the light emitting part; forming the metal layer on the second thin ohmic electrode; bonding the metal layer and the conductive support substrate such that a metal bonding layer is interposed between the metal layer and the conductive support substrate; removing the GaAs substrate; and forming the first thin ohmic electrode on a surface of the light emitting part from which the GaAs substrate is removed, wherein the step of forming the light emitting part includes epitaxially growing the p-type current spreading layer, the p-type cladding layer, the active layer, the n-type cladding layer, and the n-type current spreading layer on the GaAs substrate in this order.

Such a method can fabricate the above inventive semiconductor light emitting device. In particular, since the step of forming the light emitting part whose each layer is made of an AlGaInP-based semiconductor layer includes epitaxially growing the p-type current spreading layer, the p-type cladding layer, the active layer, the n-type cladding layer, and the n-type current spreading layer on the GaAs substrate in this order, each layer of the light emitting part can have matched lattice constant and be formed of a high quality crystal, resulting in high luminous efficiency.

The present invention can inhibit spread of current on the side of the n-type current spreading layer (the opposite side of the light extracted surface) and draw current on the side of the p-type current spreading layer (the side of the light extracted surface) near the second thin ohmic electrode (the electrode opposite to the light extracted surface), thereby enabling light to be emitted at a position far away from the first thin ohmic electrode (the electrode on the light extracted surface), as described previously. The invention can thus obtain a P-side-up, metal reflection type of semiconductor light emitting device having high luminance.

### BRIEF DESCRIPTION OF DRAWINGS

FIG. 1 is a schematic cross-sectional view of an exemplary embodiment of the semiconductor light emitting device of the present invention;
FIG. 2 is a cross-sectional view showing the steps of an exemplary embodiment of the method of producing a semiconductor light emitting device of the present invention;
FIG. 3 is a graph showing the luminous efficiency in example 1 and comparative example 1; and
FIG. 4 is a diagram showing routes of current in example 1 and comparative example 1.

### DETAILED DESCRIPTION OF THE PREFERRED EMBODIMENTS

An embodiment of the present invention will hereinafter be described in detail with reference to the drawings, but the present invention is not limited to this embodiment.

Although the achievement of high reliability needs use of a P-side-up light emitting device, it is more difficult to fabricate a P-side-up, metal reflection type of light emitting device with high luminance than the N-side up, as described previously.

The arrangement of electrodes is optimized or a thick window layer (or current spreading layer) is used as countermeasures of this problem. There is however room for improvement in luminous efficiency.

Accordingly, the present inventors have diligently considered how a P-side-up light emitting device of metal reflection type can have a light emission characteristics of high luminance, and consequently found the following, thereby brought the present invention to completion.

When each layer of a light emitting part is made of an AlGaInP-based semiconductor layer, and the lattice constant of an n-type current spreading layer matches the lattice constant of an n-type cladding layer, no large band offset due to a hetero interface occurs in the boundary between the n-type current spreading layer and the n-type cladding layer, and a band offset due to a mixing ratio of Al, Ga, and In can be reduced. Spread of current is thereby inhibited on the side of the n-type current spreading layer (the opposite side of the light extracted surface) and current on the side of the p-type current spreading layer (the side of the light extracted surface) is drawn near the second thin ohmic electrode (the electrode opposite to the light extracted surface). Light can therefore be emitted at a position far away from the first thin ohmic electrode (the electrode on the light extracted surface). Thus, a light emitting device having high luminance can be obtained.

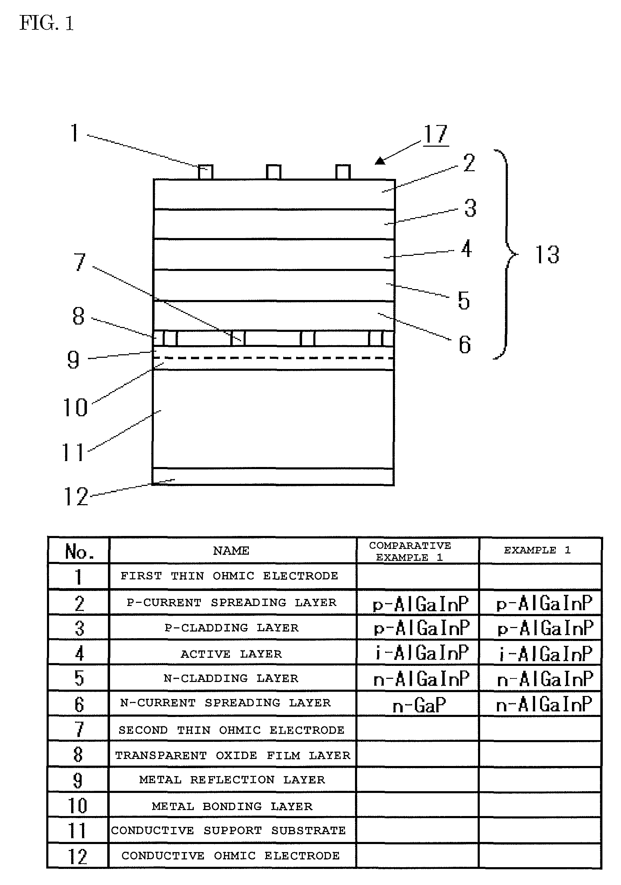

FIG. 1 is a schematic cross-sectional view of an exemplary semiconductor light emitting device according to the present invention.

The semiconductor light emitting device of the present invention 17 shown in FIG. 1 has a conductive support substrate 11, a metal bonding layer 10 disposed on the conductive support substrate 11, a metal reflection layer 9 disposed on the metal bonding layer 10, a transparent oxide film layer 8 disposed on the metal reflection layer 9, and a light emitting part 13 disposed on the transparent oxide film layer 8.

The light emitting part 13 is a semiconductor layer including an n-type current spreading layer 6, an n-type cladding layer 5 disposed on the n-type current spreading layer 6, an active layer 4 disposed on the n-type cladding layer 5, a p-type cladding layer 3 disposed on the active layer 4, and a p-type current spreading layer 2 disposed on the p-type cladding layer 3.

The semiconductor light emitting device 17 is thus a P-side-up, metal reflection type of light emitting device.

Each layer of the light emitting part 13 is an AlGaInP-based semiconductor layer. More specifically, the p-type current spreading layer 2 is a p-(AlₓGa₁-ₓ)_{y}In_{1-y}P layer (referred to as AlGaInP below), where 0≤x≤1 and 0<y<1. The p-type cladding layer 3 is a p-AlGaInP layer. The active layer 4 is an i-AlGaInP layer. The n-type cladding layer 5 is an n-AlGaInP layer. The n-type current spreading layer 6 is an n-AlGaInP layer.

A first thin ohmic electrode 1 and a pad electrode (not shown) are provided so as to partially cover the p-type current spreading layer 2. A second thin ohmic electrode 7 is partially provided between the metal reflection layer 9 and the n-type current spreading layer 6.

The first thin ohmic electrode 1 and the second thin ohmic electrode 7 are disposed so as not to overlap each other when these electrodes are seen from the upper surface (when the electrodes are seen in the direction from the p-type current spreading layer 2 side to the n-type current spreading layer 6).

The lattice constant matches between the n-type current spreading layer 6 and the n-type cladding layer 5.

This lattice constant match prevents the occurrence of large band offset due to a hetero interface in the boundary between the n-type current spreading layer 6 and the n-type cladding layer 5 and enables a band offset due to a mixing ratio of Al, Ga, and In to be reduced. Since the spread of current is thereby inhibited on the side of the n-type current spreading layer (the opposite side of the light extracted surface) and current on the side of the p-type current spreading layer (the side of the light extracted surface) is drawn near the second thin ohmic electrode (the electrode opposite to the light extracted surface), light can be emitted at a position far away from the first thin ohmic electrode (the electrode on the light extracted surface). In this manner, a P-side-up, metal reflection type of semiconductor light emitting device having high luminance can be obtained.

The lattice constant mismatching rate between the the n-type current spreading layer 6 and the n-type cladding layer 5 is preferably 0.5% or less.

When the lattice constant mismatching rate between the the n-type current spreading layer 6 and the n-type cladding layer 5 is 0.5% or less, the spread of current can be more effectively inhibited on the side of the n-type current spreading layer 6, and a light emitting device having higher luminance can be obtained.

The light emitting part 13 preferably has a total thickness of 10 µm or less.

When the total thickness of the light emitting part is 10 µm or less, warp of a wafer can be effectively inhibited, and a decrease in yield can be prevented in a fabrication process of chips of a light emitting device.

The lattice constant of each layer of the light emitting part 13 preferably matches the lattice constant of an adjacent layer.

When the lattice constant of each layer of the light emitting part 13 matches the lattice constant of an adjacent layer, each layer of the light emitting part 13 can have good crystallinity, and a decrease in the luminous efficiency due to the quality of crystal can be prevented.

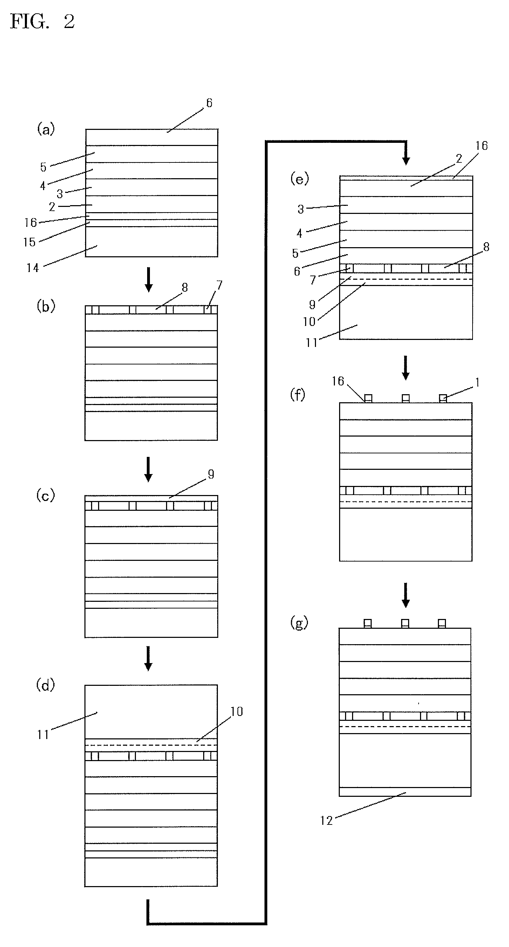

A method of producing a semiconductor light emitting device according to the present invention will now be described with reference to FIG. 2 at (a) to (g).

FIG. 2 shows at (a) to (g) a cross-sectional view of the steps of an exemplary embodiment of the method of producing a semiconductor light emitting device of the present inventuon.

First, an etching stop layer 15 of p-Ga_{0.5}In_{0.5}P, a contact layer 16 of p-GaAs, the p-type current spreading layer 2 of p-(Al_{0.4}Ga_{0.6})_{0.5}In_{0.5}P, the p-type cladding layer 3 of p-Al_{0.5}In_{0.5}P, the active layer 4 of undoped (Al_{0.1}Ga_{0.9})_{0.5}In_{0.5}P, the n-type cladding layer 5 of n-Al_{0.5}In_{0.5}P, and the n-type current spreading layer 6 of n-(Al_{0.6}Ga_{0.4})_{0.5}In_{0.5}P are deposited on the GaAs substrate 14 in this order (See FIG. 2 at (a)) by the metalorganic vapor phase epitaxy method (referred to as a MOVPE method below).

This undoped active layer 4 is not limited to a bulk type, and may be a multi type, a multiple quantum well (MQW) type, or another type.

Exemplary raw materials that can be used in the MOVPE method include organic metal compound such as trimethylgallium (TMGa), triethylgallium (TEGa), trimethylaluminum (TMA1), and trimethylindium (TMIn), and a hydroxide gas such as arsine (AsH₃) and phosphine (PH₃).

Monosilane (SiH₄) can be used as a raw material of an n-type dopant. Bis(cyclopentadienyl)magnesium (Cp₂Mg) may be used as a raw material of a p-type dopant.

Exemplary raw materials that can be used as the n-type dopant also include hydrogen selenide (H₂Se), disilane (Si₂H₆), diethyltelluride (DETe), and dimethyltelluride (DMTe). Exemplary raw materials that can be used as the p-type dopant also include dimethylzinc (DMZn) and diethylzinc (DEZn).

Next, the transparent oxide film layer 8 and the second thin ohmic electrode 7 are formed on the surface of the n-type current spreading layer 6 (See FIG. 2 at (b)).

Specifically, after an SiO₂ film is formed as the transparent oxide film layer with a plasma chemical vapor deposition (CVD) apparatus, an opening is formed by a photolithography method and an etching method. More specifically, the opening is formed by removing the transparent oxide film layer at a region where no resist pattern is formed by using a hydrofluoric-acid-based etchant as an etching solution. An AuSi alloy that is a material of the second thin ohmic electrode 7 is then deposited in the opening by a vacuum deposition method.

Then, an Al layer as a reflection layer, a Ti layer as a barrier layer, and an Au layer as a bonding layer are formed on the surface of the transparent oxide film layer 8 and the second thin ohmic electrode 7 in this order by the vacuum deposition method or a sputtering method. The metal reflection layer 9 is formed by these layers (See FIG. 2 at (c)).

The material of the metal reflection layer may be selected according to a wavelength of light emitted from the active layer such that the material has high reflectance with respect to this wavelength of light.

A support substrate composed of the metal bonding layer 10 stacked on a conductive silicon substrate 11 (a conductive support substrate) is then prepared. Specifically, the metal bonding layer 10 that is conductive and ohmic is formed on the conductive silicon substrate 11 by depositing a Ti contact electrode, an Ni barrier layer, and an Au bonding layer on this substrate in this order by the vacuum deposition method. A surface of the metal bonding layer 10 is bonded to a surface of the metal reflection layer 9 so that a bonding structure is established between mechanically and electrically connected surfaces (See FIG. 2 at (d)).

This bonding process is performed in such a manner that after the pressure of the interior of a bonding apparatus is adjusted to a prescribed pressure, the piled semiconductor stacked structure and support substrate are pressed through a jig, heated to a prescribed temperature, and held in this state for a prescribed time. Specifically, the pressure is 7000 N; the temperature is 350°C; the time is 30 minutes.

The GaAs substrate 14 is then completely removed selectively from the bonding structure with an etchant for etching GaAs, so that the etching stop layer 15 is exposed.

An exemplary etchant for etching GaAs is a mixed solution of ammonia water and hydrogen peroxide water.

The etching stop layer 15 is then removed by etching with a designated etchant from the bonding structure from which the GaAs substrate has been removed (See FIG. 2 at (e)).

If the etching stop layer is made of an AlGaInP compound semiconductor, then the designated etchant may be an etchant containing hydrochloric acid.

A first ohmic electrode including the first thin ohmic electrode 1 is then formed at a prescribed position by the photolithography method and the vacuum deposition method. This first ohmic electrode is composed of a circular electrode (not shown) and a thin electrode and can be formed, for example, by depositing Ti, AuBe, and Au in this order.

In this case, the first thin ohmic electrode 1 is formed at a position at which the first thin ohmic electrode 1 does not overlap the second thin ohmic electrode 7.

The contact layer 16 (p-GaAs) is then removed by etching (See FIG. 2 at (f)). In this etching, the first ohmic electrode including the first thin ohmic electrode 1 is used as a mask.

It is to be noted that after the contact layer 16 is removed, the p-type current spreading layer 2 may be roughened by using a prescribed etchant and the first ohmic electrode including the first thin ohmic electrode 1 as a mask.

A conductive, ohmic electrode 12 is then formed on substantially the entire back surface of the conductive support substrate 11 by the vacuum deposition method (See FIG. 2 at (g)).

The ohmic electrode 12 on the back surface is formed by depositing Ti and Au on the bottom surface of the support substrate in this order.

An alloying process is then performed to form the electrical connection between each of the ohmic electrode and semiconductor later or semiconductor substrate.

An example of this process is to perform a heat treatment at 400°C under an inert atmosphere of a nitrogen atmosphere for five minutes.

A pad electrode is subsequently formed by the photolithography method and the vacuum deposition method on a part of the surface of the first ohmic electrode: specifically on the circular electrode. The pad electrode is formed, for example, by depositing Ti and Au on the surface of the circular electrode in this order. This operation forms a bonding structure. It is to be noted that no heat treatment is performed on the pad electrode.

This bonding structure is separated into devices with a dicing apparatus including a dicing blade. This operation forms plural semiconductor light emitting devices 17 according to the present invention as shown in FIG. 1.

It is to be noted that FIG. 1 omits the contact layer 16 just under the first thin ohmic electrode 1.

Since the above step of forming the light emitting part whose each layer is made of an AlGaInP-based semiconductor layer includes epitaxially growing the p-type current spreading layer, the p-type cladding layer, the active layer, the n-type cladding layer, and the n-type current spreading layer on the GaAs substrate in this order, the lattice constant can match among the layers of the light emitting part. The layers of the light emitting part can have good crystallinity and thereby high luminous efficiency.

### EXAMPLES

The present invention will be more specifically described below with reference to an example and a comparative example, but not limited to this example.

### (Example 1)

A semiconductor light emitting device was fabricated by the producing method shown in FIG. 2.

The p-type current spreading layer 2 was made of p-(Al_{0.4}Ga_{0.6})_{0.5}In_{0.5}P; the p-type cladding layer 3 was made of p-Al_{0.5}In_{0.5}P; the active layer 4 was made of undoped (Al_{0.1}Ga_{0.9})_{0.5}In_{0.5}P; the n-type cladding layer 5 was made of n-Al_{0.5}In_{0.5}P; and the n-type current spreading layer 6 was made of n-(Al_{0.6}Ga_{0.4})_{0.5}In_{0.5}P.

The lattice constant mismatch rate between the n-type current spreading layer 6 and the n-type cladding layer 5 was 0.5% or less. The total thickness of the light emitting part 13 was 10 µm or less.

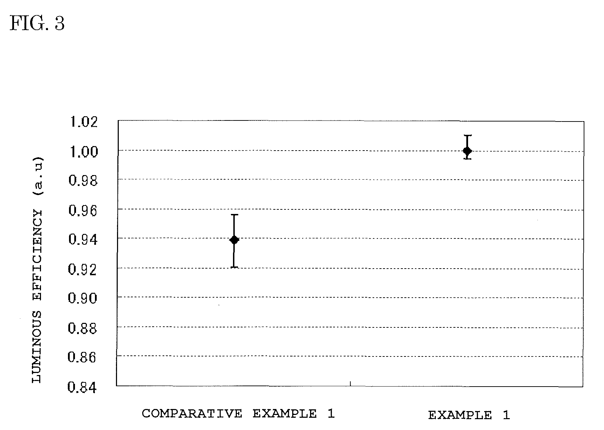

The luminous efficiency of the semiconductor light emitting device in example 1 was measured. The luminous efficiency was calculated by the following expression. The result of the measurement is shown in FIG. 3.

Luminous efficiency = Output (mW)/Applied electrical power (mW)

### (Comparative Example 1)

A semiconductor light emitting device was fabricated in the same manner as example 1 except that the n-type current spreading layer 6 was made of n-GaP.

The luminous efficiency of the semiconductor light emitting device in comparative example 1 was measured in the same manner as example 1. The result of the measurement is shown in FIG. 3.

It is to be noted that the luminous efficiency was standardized such that the luminous efficiency in example 1 was 1.

As shown in FIG. 3, the luminous efficiency in example 1 was improved by about 6% compared with in comparative example 1.

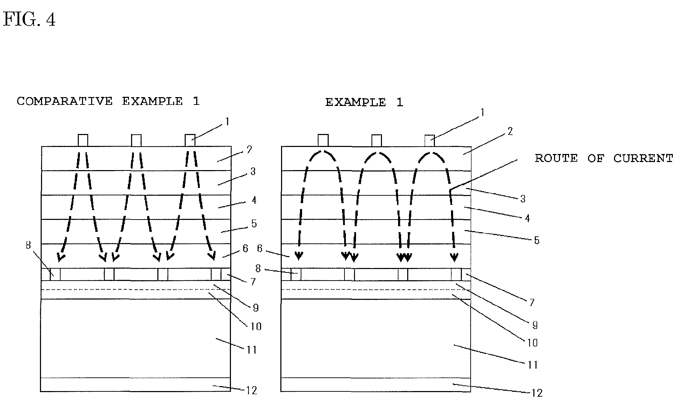

FIG. 4 shows routes of current in example 1 and comparative example 1.

In comparative example 1, there was a hetero interface of an AlGaInP/GaP interface between the n-type cladding layer 5 and the n-type current spreading layer 6. As shown in FIG. 4, current was thereby spread on the side of the n-type current spreading layer 6, and the spreading of current was inhibited on the side of the p-type current spreading layer 2.

In example 1, in contrast, there was no hetero interface between the n-type cladding layer 5 and the n-type current spreading layer 6, unlike comparative example 1. As shown in FIG. 4, the spreading of current was inhibited on the side of the n-type current spreading layer 6, and current on the side of the p-type current spreading layer 2 was drawn near the second thin ohmic electrode 7. Light was thereby able to be emitted at a position far away from the electrode on the light extracted surface (the first thin ohmic electrode 1). Thus, the light emitting device achieved high luminance.

It is to be noted that the present invention is not limited to the foregoing embodiment. The embodiment is just an exemplification, and any examples that have substantially the same feature and demonstrate the same functions and effects as those in the technical concept described in claims of the present invention are included in the technical scope of the present invention.

## Claims

1. A semiconductor light emitting device comprising:
a conductive support substrate;
a metal layer disposed on the conductive support substrate;
a light emitting part disposed above the metal layer, the light emitting part including an n-type current spreading layer, an n-type cladding layer, an active layer emitting light, a p-type cladding layer, and a p-type current spreading layer in this order;
a first thin ohmic electrode partially covering the p-type current spreading layer; and
a second thin ohmic electrode partially provided between the metal layer and the n-type current spreading layer, wherein
each layer of the light emitting part is made of an AlGaInP-based semiconductor layer,
the first thin ohmic electrode and the second thin ohmic electrode are disposed so as not to overlap when seen from an upper surface of the semiconductor light emitting device, and
the n-type current spreading layer is a semiconductor layer whose lattice constant matches a lattice constant of the n-type cladding layer.

2. The semiconductor light emitting device according to claim 1, wherein the lattice constant of the n-type current spreading layer matches the lattice constant of the n-type cladding layer at a lattice constant mismatching rate of 0.5% or less.

3. The semiconductor light emitting device according to claim 1 or claim 2, wherein the light emitting part has a total thickness of 10 µm or less.

4. A method of producing a semiconductor light emitting device according to any one of claims 1 to 3, comprising:
forming the light emitting part on a GaAs substrate;
forming the second thin ohmic electrode on the light emitting part;
forming the metal layer on the second thin ohmic electrode;
bonding the metal layer and the conductive support substrate such that a metal bonding layer is interposed between the metal layer and the conductive support substrate;
removing the GaAs substrate; and
forming the first thin ohmic electrode on a surface of the light emitting part from which the GaAs substrate is removed, wherein
the step of forming the light emitting part includes epitaxially growing the p-type current spreading layer, the p-type cladding layer, the active layer, the n-type cladding layer, and the n-type current spreading layer on the GaAs substrate in this order.
